Europäisches Patentamt

European Patent Office

Office européen des brevets

(11) Veröffentlichungsnummer: **0 268 930 B1**

(19)

(12) **EUROPÄISCHE PATENTSCHRIFT**

(45) Veröffentlichungstag der Patentschrift: **22.04.92**

(21) Anmeldenummer: **87116606.2**

(22) Anmeldetag: **10.11.87**

(51) Int. Cl.5: **H03K 17/08**

(54) **Schaltungsanordnung eines sich selbst schützenden Leistungsschalters.**

(30) Priorität: **11.11.86 DE 3638399**

(43) Veröffentlichungstag der Anmeldung:
**01.06.88 Patentblatt 88/22**

(45) Bekanntmachung des Hinweises auf die
Patenterteilung:
**22.04.92 Patentblatt 92/17**

(84) Benannte Vertragsstaaten:
**CH DE FR GB IT LI SE**

(56) Entgegenhaltungen:
**EP-A- 0 046 962**
**EP-A- 0 154 062**
**FR-A- 2 482 800**

(73) Patentinhaber: **SIEMENS AKTIENGESELL-**
**SCHAFT**
**Wittelsbacherplatz 2**
**W-8000 München 2(DE)**

(72) Erfinder: **Hebenstreit, Ernst, Dipl.-Ing.**
**Am Blütenanger 14**
**W-8000 München 50(DE)**

**Beschreibung**

Die Erfindung betrifft eine Schaltungsanordnung eines sich selbst schützenden Leistungsschalters mit Anschlußklemmen für Steuersignale, Versorgungsspannung, Statussignal und Last, mit einer Ansteuer- und Überwachungseinrichtung für mindestens eine Leistungsschaltstufe, die mindestens eine erste Ansteuereinheit und eine zweite Ansteuereinheit enthält, zwischen die ein Impulsübertrager geschaltet ist, mit in der zweiten Ansteuereinheit vorgesehenen, an die Sekundärwicklung des Impulsübertragers angeschlossenen Mitteln, die die Leistungsschaltstufe abhängig von den Steuersignalen ein- und ausschalten und die die Leistungsschaltstufe bei Überlast sperren und über einen steuerbaren Schalter eine Last an die Sekundärwicklung schalten, mit Mitteln in der ersten Ansteuereinheit, die das Einschalten der Last als Überlast bewerten.

Eine solche Schaltungsanordnung ist z. B. in der europäischen Patentanmeldung 0 046 962 beschrieben worden. Sie enthält als Leistungsschaltstufe einen Bipolartransistor. Wird dieser über-lastet, so steigt seine Emitter-Kollektorspannung an und steuert einen Thyristor leitend. Dieser Thyristor schließt die Sekundärwicklung des Impulsübertragers und damit die Basis-Emitterstrecke des Bipolartransistors kurz. Der Bipolartransistor wird damit ausgeschaltet. Dieser Kurzschluß kann auf der Primärseite des Impulsübertragers als Überlast detektiert werden. Der in der zweiten Ansteuereinheit auftretende Kurzschluß hat primärseitig in der ersten Ansteuereinheit einen hohen Strom zur Folge, der durch die erste Ansteuereinheit aufgebracht werden muß. Die erste Ansteuereinheit muß daher im Störfall abgeschaltet werden, wodurch die zweite Ansteuereinheit stromlos wird.

Moderne Steuerschaltungen bedienen sich im allgemeinen digitaler Mittel, die auch im Störfall nicht von der Versorgungsspannung getrennt werden dürfen.

Der Erfindung liegt die Aufgabe zugrunde, eine Schaltungsanordnung der geschilderten Art derart weiterzubilden, daß im Störfall eine potentialfreie Spannungsversorgung der zweiten Ansteuereinheit gewährleistet bleibt.

Diese Aufgabe wird dadurch gelöst, daß die erste Ansteuereinheit die Steuersignale in Impulsketten umwandelt, daß die zweite Ansteuereinheit die Impulsketten zu Steuersignalen regeneriert, daß die Mittel in der zweiten Ansteuereinheit einen von den regenerierten Steuersignalen angesteuerten Treiber (TE6) zum Schalten der Leistungsschaltstufen enthalten, daß der Schalter ausschließlich die Last schaltet, daß der Treiber bei Überlast gesperrt wird und daß der Schalter bei Überlast vom regenerierten Steuersignal leitend gesteuert wird.

In der europäischen Patentanmeldung 0 154 062 ist eine Schaltungsanordnung eines sich selbst schützenden Leistungsschalters beschrieben worden, bei der Steuersignale primärseitig in Impulse umgewandelt werden, die sekundärseitig wieder zu Steuersignalen regeniert werden. Auch bei dieser Schaltunganordnung wird die zweite Ansteuereinheit potentialfrei über den Impulsübertrager mit Spannung versorgt. Bei Überlast wird die Leistungsschaltstufe jedoch nicht sekundärseitig abgeschaltet, sondern es wird das auf die Primärseite zurückgemeldete Störsignal dazu verwendet, die Abschaltung über die Primärseite vorzunehmen. Dies ist wegen der damit verbundenen Signallaufzeit nachteilig. Dieser Nachteil wird erfindungsgemäß dadurch vermieden, daß die Abschaltung sekundärseitig erfolgt, wobei lediglich das Störsignal zur Primärseite zurückgemeldet wird.

Die Erfindung wird im folgenden anhand der FIG 1 bis 8 näher erläutert. Es zeigen:

FIG 1    ein Blockschaltbild einer erfindungsgemäßen Schaltungsanordnung für einen sich selbst schützenden Leistungsschalter,

FIG 2    ein Beispiel eines entsprechenden Signalaufplanes nach FIG 1,

FIG 3    ein Blockschaltbild einer erfindungsgemäßen Schaltungsanordnung zum Ansteuern einer Halbbrücke,

FIG 4    ein erstes Ausführungsbeispiel einer Schaltungsanordnung für die erste Ansteuereinheit nach FIG 3 bzw. 1,

FIG 5    ein zweites Ausführungsbeispiel einer Schaltungsanordnung für die erste Ansteuereinheit nach FIG 3 bzw. 1,

FIG 6    ein Ausführungsbeispiel einer Schaltungsanordnung für die zweite Ansteuereinheit nach FIG 3 bzw. 1,

FIG 7a    erstes Beispiel für eine Leistungsschaltstufe,

FIG 7b    zweites Beispiel für eine Leistungsschaltstufe,

FIG 8    einen entsprechenden Signallaufplan nach den FIG 3, 4 und 6.

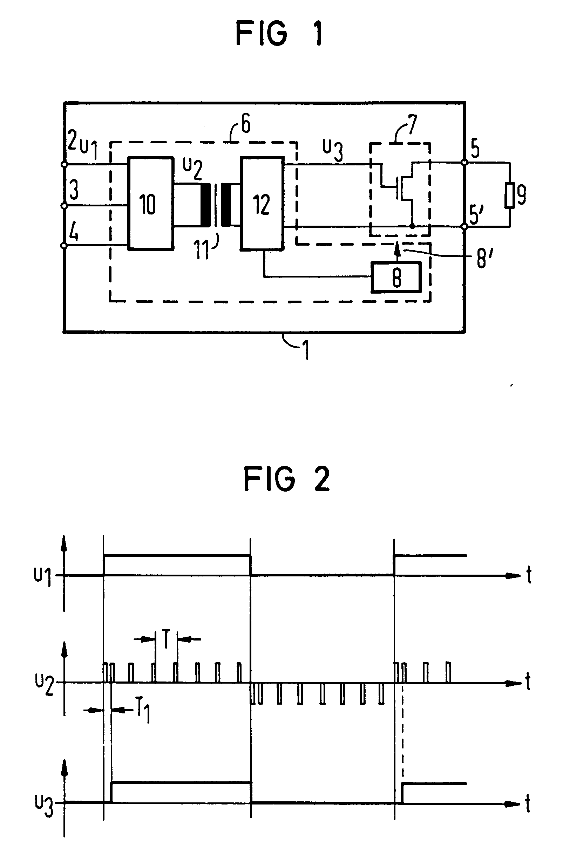

Das Blockschaltbild nach FIG 1 zeigt einen erfindungsgemäßen sich selbst schützenden Leistungsschalter 1, der als Modul ausgeführt ist. Das Modul ist mit Anschlußklemmen 2, 3, 4, 5, 5′ mindestens für Steuersignale, Versorgungsspannung, Statusanzeige und Last versehen. Im Inneren des Moduls ist eine Ansteuer- und Überwachungseinrichtung 6 angeordnet, die mindestens eine erste Ansteuereinheit 10 und eine zweite Ansteuereinheit 12 enthält, zwischen denen ein Impulsübertrager 11 geschaltet ist. Die erste Ansteuereinheit 10 ist mit einer Anschlußklemme 2 für das Steuersignal, einer Anschlußklemme 3 für das Statussignal und einer Anschlußklemme 4 für die Versorgungsspannung verbunden. An die zweite Ansteuereinheit 12 ist eine Leistungsschaltstufe 7 angeschlossen, die mit Anschlußklemmen, 5, 5′ für die zu schaltende Last 9 versehen ist.

Der Eingang für das Steuersignal in der ersten Ansteuereinheit 10 ist zweckmäßigerweise Logik-kompatibel, z.B. 15 V-CMOS- und/oder TTL-kompatibel ausgeführt. Liegt ein entsprechendes, z.B. pulsweitenmoduliertes Steuersignal an der Anschlußklemme 2 an, so sind in der ersten Ansteuereinheit 10 Mittel vorgesehen, die diesem Steuersignal Impulsketten zuordnet, die über den Impulsübertrager 11 entsprechend transformiert dem Eingang der zweiten Ansteuereinheit 12 zugeführt werden.

Diese zweite Ansteuereinheit 12 enthält Mittel, die diese Impulsketten in Blocksignale regenerieren, die dafür geeignet sind, die Leistungsschaltstufe 7 zu steuern. Außerdem enthält die zweite Ansteuereinheit 12 noch Mittel zur Erfassung von Störungen, wie Kurzschluß, Überspannung und Übertemperatur, die im Störfall die Leistungsschaltstufe 7 übergeordnet sperren und zusätzliche der ersten Ansteuereinheit 10 anzeigen, daß ein Störfall vorliegt. Diese erste Ansteuereinheit 10 enthält darüberhinaus noch Vorrichtungen, die diesen Störfall erkennen und ein Statussignal generiert, das an der Anschlußklemme 3 anliegt.

Den möglichen Verlauf eines pulsweitenmodulierten Steuersignals $u_1$, welches an der Anschlußklemme 2 anliegt, zeigt FIG 2 oben. Ein mögliches Signal $u_2$, wie es der Primärseite des Impulsübertragers 11 zugeführt wird und ein entsprechendes Blocksignal $u_3$ zur Steuerung der Leistungsschaltstufe 7 ist in FIG 2 unten dargestellt. Mit ansteigender Flanke des Steuersignals $u_1$ wird in der ersten Ansteuereinheit 10 z.B. ein Startimpuls generiert, dem anschließend eine um $T_1$ verzögerte Pulsfolge folgt. Diese Impulskette, also Startimpuls und nachfolgende Pulsfolge, hat beispielsweise positive Polarität. Diese Pulsfolge wird solange erzeugt, bis das Steuersignal $u_1$ von logisch "1" auf "0" zurückspringt. Mit abfallender Flanke des Steuersignals wird wieder ein Startimpuls, allerdings jetzt mit negativer Polarität, erzeugt, dem ebenfalls eine Pulsfolge - wieder um $T_1$ verögert - folgt. Diese Pulsfolge weist auch negative Polarität auf. Mit erneut ansteigender Flanke des Steuersignals $u_1$ wird die Polarität der Impulskette wieder positiv, usw. Die zweite Ansteuereinheit 12 regeneriert nun aus den an ihrem Eingang anliegenden Impulsketten entsprechende Blocksignale $u_3$ zur Steuerung der Leistungsschaltstufe 7. Diese Blocksignale $u_3$ entsprechen im wesentlichen dem Verlauf des Steuersignals $u_1$. Die ansteigende Flanke des Blocksignals erscheint aber erst um $T_1$ verzögert. Dazu enthält die zweite Ansteuereinheit 12 eine Schaltungsanordnung, die mit ansteigender Flanke des ersten Impulses der Pulsfolge mit positiver Polarität ein Flip-Flop setzt, welches mit der ansteigenden Flanke des Startimpulses negativer Polarität rückgesetzt wird. Die Pulsfolgen weisen z.B. eine Periodendauer T von 100 μsec auf. Die Impulsbreiten der Startimpulse und der Impulse der Pulsfolgen sind z.B. gleich und liegen ungefähr zwischen 300 nsec und einer 1 μsec und die zeitliche Verzögerung $T_1$ zwischen Startimpuls und Impulsfolge ist etwas größer als die Impulsbreite gewählt.

Die Verwendung eines entsprechenden Impulsübertragers 11 gegenüber einem herkömmlichen Transformator hat den Vorteil, daß damit Signale mit geringen Impulsbreiten übertragen werden können. Der Impulsübertrager 11 muß natürlich so gewählt werden, daß die Impulse ohne wesentliche Zeitverzögerung und ohne wesentliche Impulsveränderungen übertragen werden.

Im Blockschaltbild nach FIG 1 sind zusätzlich in der Ansteuer-und Überwachungseinrichtung 6 Mittel 8 zum Überwachen von Überstrom, Überspannungen und Übertemperatur vorgesehen. Zur Erfassung der Übertemperatur wird zweckmäßigerweise der Leistungsschaltstufe 7 z.B. ein Temperatursensor 8′ zugeordnet.

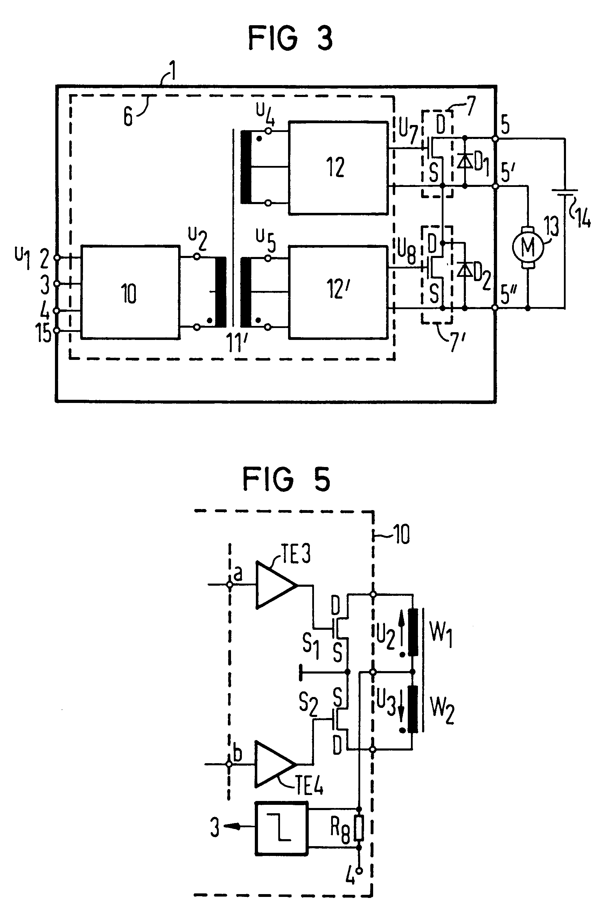

In FIG 3 ist das Blockschaltbild einer erfindungsgemäßen Schaltungsanordnung zum Ansteuern einer Halbbrücke dargestellt. Dieser besonders für Motorsteuerung geeignete, sich selbst schützende Leistungsschalter 1 weist eine Ansteuer-und Überwachungseinrichtung 6 auf. Die Ansteuerund Überwachungseinrichtung 6 hat eine erste Ansteuereinheit 10, die - wie im Zusammenhang mit FIG 1 bereits erläutert worden ist - mit Anschlußklemmen 2, 4, 3 für das Steuersignal, Versorgungsspannung und Statussignal versehen ist. Der Ausgang dieser ersten Ansteuereinheit 10 ist mit der Primärseite eines Impulsübertragers 11′ verbunden, der zwei sekundäre zueinander komplementär arbeitende Ausgänge aufweist. An jedem dieser beiden Ausgänge ist jeweils eine zweite Ansteuereinheit 12, 12′ angeschlossen. Die eine zweite Ansteuereinheit 12 ist zur Ansteuerung einer ersten Leistungsschaltstufe 7 und die andere gleich aufgebaute zweite Ansteuereinheit 12′ zur Ansteuerung einer zweiten Leistungsschaltstufe 7′ vorgesehen. Die gesamte Ansteuer- und Überwachungseinheit 6 enthält Mittel, die so aufeinander abgestimmt sind, daß z.B. bei einem Eingangssignal $u_1$ = logisch "1" die Leistungsschaltstufe 7 leitet und die Leistungsschaltstufe 7′ sperrt und bei einem Eingangssignal $u_1$ = "0" entsprechend umgekehrt.

Diese Leistungsschaltstufen 7, 7′ sind Transistoren mit Feldeffekt-Steuereingängen, z.B. MOSFETs, die zu einer Halbbrücke zusammengeschaltet sind. Dazu sind der Sourceanschluß des einen MOS-FET in 7 mit dem Drainanschluß des anderen MOS-FET in 7' verbunden. Dieser Verbindungspunkt ist mit einer ausgangsseitigen Anschlußklemme 5' des Leistungsschalters 1 verbunden. Zwei weitere ausgangsseitige Anschlußklemmen 5 und 5" sind mit dem freien Drainanschluß des einen MOS-FET in 7 mit dem freien Sourceanschluß des anderen MOS-FET in 7' verbunden. Außerdem sind den beiden MOS-FET die für jede Halbbrückensteuerung nötige Rücklaufdioden D1, D2 antiparallel geschaltet.

Dieser sich selbst schützende Leistungsschalter 1 zum Ansteuern einer Halbbrücke ist universell für Motorsteuerungen einsetzbar. Eine einfache Steuerung für eine Gleichstrommotor 13 wird dadurch erreicht, daß zwischen die Anschlußklemmen 5', 5" der Gleichstrommotor 13 und zwischen die Anschlußklemmen 5 und 5" eine entsprechende Gleichspannungsquelle 14 geschaltet wird.

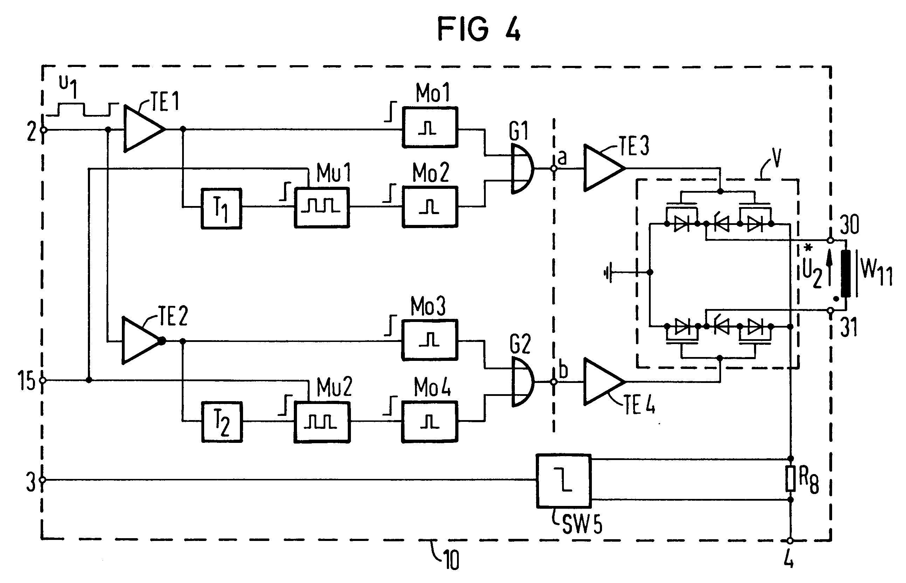

Der sich selbst schützende Leistungsschalter 1 ist zusätzlich - wie FIG 3 zeigt - mit einer weiteren Anschlußklemme 15 für eine sogenannte "Impulssperre" versehen. Bei entsprechendem Impulssperrsignal wird der gesamte Leistungsschalter 1 übergeordnet gesperrt, d.h., daß der sich selbst schützende Leistungsschalter 1 auf jeden Fall sperrt, egal welches Steuersignal u₁ an der Anschlußklemme 2 anliegt. Diese ist besonders für eine definierte Inbetriebnahme der Leistungsstufe von Vorteil. Dazu sind im sich selbst schützenden Leistungsschalter 1 zusätzliche Mittel vorgesehen, die im einzelnen anhand der im folgenden beschriebenen FIG 4 bis 6 eingehend erläutert werden.

Praktische Ausführungsbeispiele von Schaltungsanordnungen für die verschiedenen Ansteuereinheiten 10, 12 bzw. 12' gemäß FIG 3 und dazugehörige Signalverläufe werden im folgenden ausführlich dargelegt: In FIG 4 ist ein Beispiel für eine Schaltungsanordnung einer ersten Ansteuereinheit 10 dargestellt. Diese Schaltungsanordnung hat eine Anschlußklemme 2 für ein Steuersignal u₁ und eine Anschlußklemme 15 für das Impulssperrsignal. die Anschlußklemme 2 ist mit einer nicht invertierenden Treiberstufe TE1 und mit einer invertierenden Treiberstufe TE2 verbunden. Der Ausgang der Treiberstufe TE1 ist an einer monostabilen Kippstufe MO1, das auf ansteigende Flanken reagiert, angeschlossen, deren Ausgang mit dem Eingang eines ODER-Gatters G1 verbunden ist. Der Ausgang der Treiberstufe TE1 ist auch mit einem bei ansteigender Flanke einschaltenden Multivibrator MU1 verbunden, dessen Ausgang über eine monostabile Kippstufe MO2 an einen weiteren Eingang des ODER-Gatters G1 angeschlossen ist, Zwischen dem Ausgang des Treibers TE1 und dem Eingang des Multivibrators MU1 ist noch eine Verzögerungsglied T1 angeordnet. Der Ausgang des ODER-Gatters G1 ist mit einer Treiberstufe TE3 verbunden, die an die beiden Eingänge einer Halbbrücke angeschlossen ist. Die Halbbrücke hat z.B. MOS-FET mit antiparallelen Rücklaufdioden. Die Anodenseite der Halbbrücke liegt auf Massepotential, während die Kathodenseite der Halbbrücke über einen Widerstand R8 mit der Anschlußklemme 4 verbunden ist. An diese Anschlußklemme 4 wird der Pluspol einer Gleichspannungsquelle, die z.B. + 15 V liefern kann, angeschlossen.

An den Ausgang der invertierenden Treiberstufe TE2 sind in gleicher Weise eine monostabile Kippstufe MO3 und eine Reihenschaltung aus Verzögerungsglied T2, Multivibrator MU2 und monostabile Kippstufe MO4 mit anschließendem ODER-Gatter G2 geschaltet. Der Ausgang dieses ODER-Gatters G2 ist mit einer Treiberstufe TE4 verbunden, die mit den beiden Eingängen einer weiteren Halbbrücke verbunden ist. Diese Halbbrücke ist mit den gleichen Bauelementen wie oben erwähnt ausgeführt, also für jeden Zweig der Halbbrücke ein MOS-FET mit antiparalleler Rücklaufdiode. Die Anodenseite dieser Halbbrücke ist mit der Anodenseite der oben erwähnten Halbbrücke verbunden und die Kathodenseite mit der Kathodenseite der oben genannten Halbbrücke, so daß eine Vollbrücke V entsteht. Es ist dabei zweckmäßig in den beiden zu einer Vollbrücke zusammengeschalteten Halbbrückenzweigen je eine Zenerdiode in bekannter Weise zuzuschalten, um eine definierte Entmagnetisierungsspannung zu gewährleisten.

Es muß hier erwähnt werden, daß ein eigener Masseanschluß in der ersten Ansteuereinheit 10 vorgesehen ist, der aber aus Gründen der besseren Übersichtlichkeit in der Figur nicht dargestellt ist. Über die Anschlußklemme 4 werden auch die einzelnen aktiven Bauteile mit Spannung versorgt, was aber ebenfalls in FIG 4 nicht dargestellt ist. Der Ausgang der Vollbrückenschaltung ist mit Ausgangsklemmen 30, 31 verbunden, an die die primärseitige Wicklung W11 eines Impulsübertragers 11' angeschlossen ist.

Zur Eingangsstromüberwachung wird die am Widerstand R8 abfallende Spannung abgegriffen und mit einer Einheit verbunden, die ein Ausgangssignal nur dann erzeugen kann, wenn der durch den Widerstand fließende Strom einen bestimmten Regel überschreitet. Diese kann im wesentlichen ein Schwellwertschalter SW5 sein, der beim Überschreiten eines entsprechenden Sollwertes ein Ausgangssignal erzeugt. Der Ausgang dieser Einheit ist mit der Anschlußklemme 3 für das Statussignal verbunden.

Die Anschlußklemme 15 für das Impulssperresignal ist mit den beiden Multivibratoren MU1, MU2 verbunden, die bei entsprechendem Impulssperresignal übergeordnet gesperrt werden. Eine dafür geeignete Schaltungsanordnung besteht z.B. darin, daß der Ausgang des Verzögerungsgliedes T1 bzw. T2 nicht direkt mit dem Multivibrator MU1 bzw. MU2 verbunden ist, sondern dem Eingang eines UND-Gatters mit zwei Eingängen zugeführt wird, dessen Ausgang an den Multivibrator MU1 bzw. MU2 angeschlossen ist. Zugleich wäre der zweite Eingang des UND-Gatters mit der Anschlußklemme 15 verbunden. Dies führt dann dazu, daß bei angelegter "0" an die Anschlußklemme 15 die beiden Multivibratoren MU1 und MU2 übergeordnet gesperrt werden. Aus Gründen der besseren Übersichtlichkeit wurde auf eine detaillierte Darstellung dieser Einzelheit verzichtet, sondern nur schematisch durch eine Verbindungsleitung zwischen Anschlußklemme 15 und den Multivibratoren MU1 und MU2 angedeutet.

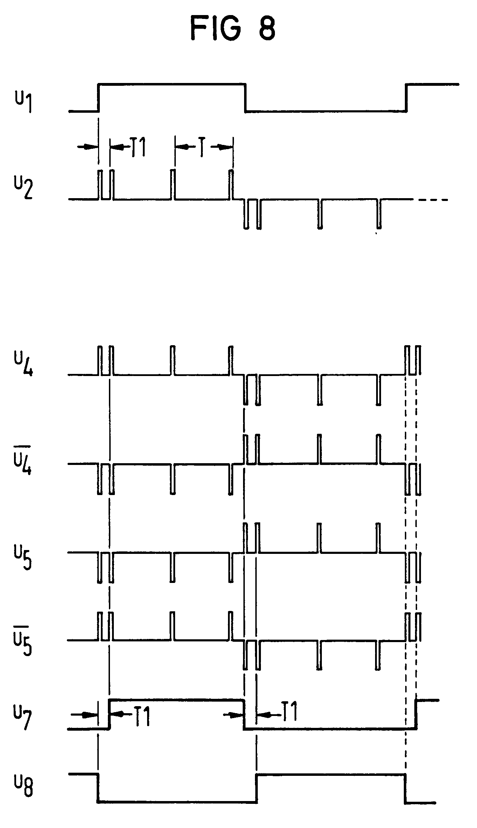

Zur Verdeutlichung der Wirkungsweise dieser ersten Ansteuereinheit 10 wird auf die Darstellung der dazugehörigen Signalverläufe in FIG 8 verwiesen. $u_1$ sei das an der Anschlußklemme 2 anstehende Steuersignal. Dieses Steuersignal $u_1$ wird über den nichtinvertierenden Treiber TE1, der dem Pegel des Steuersignals entsprechend angepaßt ist, einer monostabilen Kippstauf MO1 zugeführt, die mit ansteigender Flanke einen Impuls, nämlich den Startimpuls erzeugt. Die im Signalverlaufplan um $T_1$ verzögerte Pulsfolge wird durch das Verzögerungsglied T1, den bei ansteigender Flanke einschaltenden Multivibrator MU1 mit nachfolgendem ebenfalls mit ansteigender Flanke einschaltender monostabiler Kippstufe MO2 erzeugt. Der Multivibrator MU1 schwingt solange, wie an seinem Eingang eine logische "1" anliegt. Der Startimpuls und die Pulsfolge werden dem ODER-Gatter G1 zugeführt. Am Ausgang des Gatters G2 liegt die gleiche Impulskette an, allerdings nur dann, wenn das Steuersignal auf logisch "0" liegt. Die Ausgänge der Gatter G1 und G2 steuern jeweils einen entsprechenden Treiber TE1 und TE2, deren Ausgänge mit den Eingängen der Vollbrücke verbunden sind. Den zugehörigen Signalverlauf $u_2$ an der primären Wicklung W11 des Impulsübertragers 11 zeigt FIG 8. Es ist deutlich zu erkennen, daß die Polarität der Impulsketten bei logischer "1" des Steuersignals $U_1$ positiv und bei "0" negativ ist. Ansonsten kann auf das zur FIG 3 Gesagte verwiesen werden.

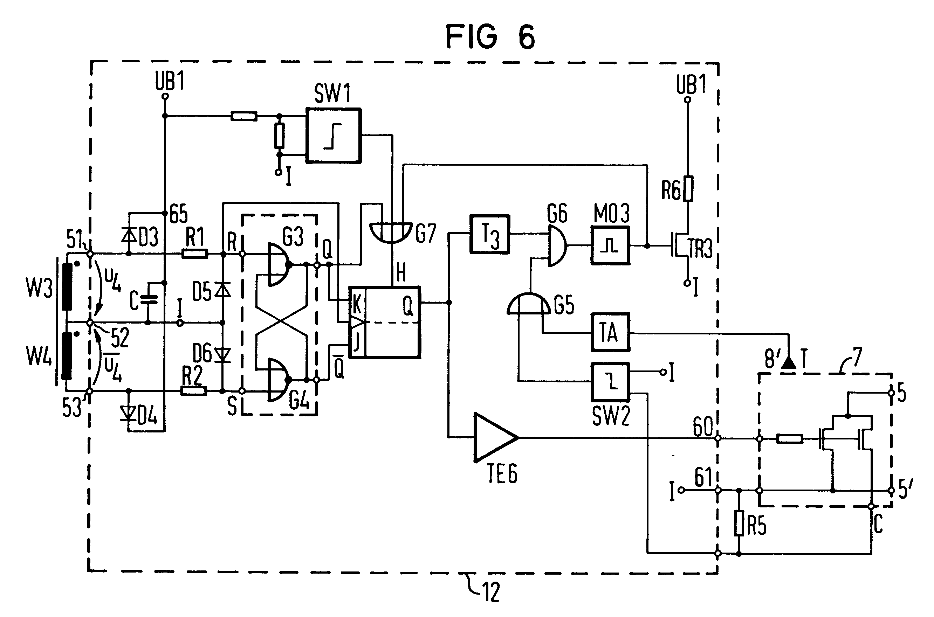

Eine andere Möglichkeit einer ersten Ansteuereinheit 10 ist in Fig 5 dargestellt. Die Schaltungsanordnung unterscheidet sich dadurch von FIG 4, daß an die Ausgänge der Treiber TE3 und TE4 nicht eine Vollbrücke angeschlossen wird, sondern zwei Schaltelemente S1 und S2. An den Ausgang des Treibers TE3 ist z.B. der Gateanschluß eines MOS-FET angeschlossen. Der Sourceanschluß dieses MOS-FET liegt auf Masse und der Drainanschluß ist über eine primäre Wicklung W1 eines Impulsübertragers mit in Reihe geschaltetem Widerstand R8 mit der Anschlußklemme 4 verbunden. An den Ausgang des Treibers TE4 ist der Gateanschluß eines zweiten MOS-FET angeschlossen. Der Sourceanschluß dieses zweiten MOS-FET liegt auf Masse und der Drainanschluß über eine zweite primäre Wicklung W2 des Impulsübertragers 11 am Verbindungspunkt des Widerstandes R8 und der Wicklung W1. Der Wicklungssinn beider primären Wicklungen ist so gewählt, daß bei abwechselndem Schalten von S1 und S2 in einer auf der Sekundärseite des Impulsübertragers 11 angebrachten Wicklung Spannungen unterschiedlicher Polarität induziert werden. Der Wicklungssinn ist in FIG 5 durch einen Punkt an der jeweiligen Wicklung markiert.

Auch hier ist es vorgesehen, die an dem Widerstand R8 abfallende Spannung - wie bereits bei FIG 5 beschrieben -z.B. einem Schwellwertschalter zuzuführen.

FIG 6 zeigt ein Schaltungsanordnung für eine zweite Ansteuereinheit 12, die mit der Sekundärseite eines Impulsübertragers 11 verbunden ist. Die Sekundärseite weist ein Wicklungspaar W3 und W4 auf. Die Wicklungen W3 und W4 dieses Wicklungspaares sind mit gleichem Wicklungssinn hintereinander geschaltet. Der Verbindungspunkt beider Wicklungen W3 und W4 ist mit einer Anschlußklemme 52 versehen. Die beiden anderen Enden der Wicklungen W3 und W4 haben Anschlußklemmen 51 und 53. In FIG 6 ist der Wicklungssinn dieses sekundären Wicklungspaares durch entsprechende Punkte gekennzeichnet.

Die zweite Ansteuereinheit 12 hat ein RS-Flip-Flop aus zwei NOR-Gattern G3 und G4. Der R-Eingang des RS-Flip-Flops ist über einen widerstand R1 mit der Anschlußklemme 51 und der S-Eingang des RS-Flip-Flops über einen Widerstand R2 mit der Anschlußklemme 53 verbunden. Die R- und S-Eingänge sind zusätzliche jeweils mit den Kathoden einer Diode D5 bzw. D6 verbunden. Die Anoden dieser zwei Dioden D5 und D6 sind mit der Anschlußklemme 52, die zugleich Bezugspotential der zweiten Ansteuereinheit ist, verbunden. Der nicht invertierende Ausgang Q des RS-Flip-Flops ist an den K-Eingang und der invertierende Ausgang Q an den J-Eingang eines JK-Flip-Flops angeschlossen. Der Takteingang diese JK-Flip-Flops ist zugleich mit dem Verbindungspunkt des Widerstands R1 und des R-Eingangs des RS-Flip-Flops verbunden. Das JK-Flip-Flop weist einen zusätzlichen Eingang H auf, der bei anliegender logischer "1" das JK-Flip-Flop rücksetzt. Dieser zusätzliche Eingang H des JK-Flip-Flops ist mit dem Ausgang eines ODER-Gatters G7 verbunden. Eine Eingang des ODER-Gatters G7 ist mit dem Q-Ausgang des RS-Flip-Flops verbunden. Der Ausgang des JK-Flip-Flops Q ist über einen entsprechenden Treiber TE6 mit einer Anschlußklemme 60 für eine Leistungsschaltstufe 7 versehen. Eine weitere Anschlußklemme 61 für die Leistungsschaltstufe 7 ist mit der Anschlußklemme 52 verbunden. An die Anschlußklemme 60 ist z.B. über einen Entkopplungswiderstand das Gate eines Leistungs-MOT-FET angeschlossen. Der Sourceanschluß dieses MOS-FET ist mit der Klemme 61 verbunden.

Zur potentialfreien Stromversorgung der gesamten zweiten Ansteuereinheit 12 sind zwei Dioden D3 und D4 und eine Kondensator C vorgesehen. Die Anode der Diode D3 ist mit der Anschlußklemme 51 und die Anode der Diode D4 ist mit der Anschlußklemme 53 verbunden. Die beiden Kathoden der Dioden D3 und D4 sind zusammengeschaltet. Zwischen diesem Verbindungspunkt 65 und der Anschlußklemme 52 liegt der Kondensator C. Am Verbindungspunkt 65 liegt dann die zur Spannungsversorgung der zweiten Ansteuereinheit 12 notwendige und durch Gleichrichtung der positiven und negativen Impulsketten gewonnener Spannung UB 1 an. Ein Schwellwertschalter SW1 ist über einen Spannungsteiler an diesen Verbindungspunkt 65 angeschlossen. Der Ausgang dieses Schwellwertschalters SW1 ist mit einem Eingang des ODER-Gatters G7 verbunden. Steigt die Spannung über einen vorgegebenen Wert an, so ist es bei diesem Schwellwertschalter SW1 vorgesehen, eine logische "1" an den Eingang des ODER-Gatters G7 zu legen. Der Q-Ausgang des JK-Flip-Flops ist auch über ein Verzögerungsglied T2 mit einem Eingang eines UND-Gatters G6 verbunden. Der andere Eingang dieses UND-Gatters G6 ist an den Ausgang eines ODER-Gatters G5 angeschlossen. Dieses ODER-Gatter G5 weist zwei Eingänge auf, dessen Eingänge mit einem Schwellwertschalter SW2 und einer temperaturempfindlichen Anordnung TA verbunden sind. Der Schwellwertschalter SW2 ist dazu vorgesehen, den Laststrom des Leistungsschalters 7 zu messen. Liegt dieser Laststrom über einem vorgegebenen Wert, so gibt dieser Schwellwertschalter SW2 eine logische "1" an den Eingang des Gatters G5. Die temperaturempfindliche Anordnung dient dazu, eine etwaige auftretende Übertemperatur am Leistungsschalter zu erkennen und durch eine logische "1" dem Eingang des Gatters G5 zu signalisieren. Im einfachsten Fall besteht diese temperaturempfindliche Anordnung aus einem Temperaturfühler 8', der entsprechend an der Leistungsschaltstufe 7 angeordnet ist.

Der Ausgang des UND-Gatters G6 ist an den Eingang einer monostabilen Kippstufe MO3 angeschlossen, der etwa eine Einschaltdauer von 1 bis 10 msec aufweist. Der Ausgang dieser monostabilen Kippstufe MO3 ist zum einen mit einem weiteren Eingang des ODER-Gatters G7 und zum anderen z.B. mit dem Gateanschluß eines Feldeffekttransistors TR3 verbunden. Der Sourceanschluß dieses Feldeffekttransistors TR3 liegt auf dem gleichen Potential wie die Anschlußklemme 52 und der Drainanschluß des Feldeffekttransistors TR3 ist über einen Widerstand R6 mit dem Verbindungspunkt 65 verbunden.

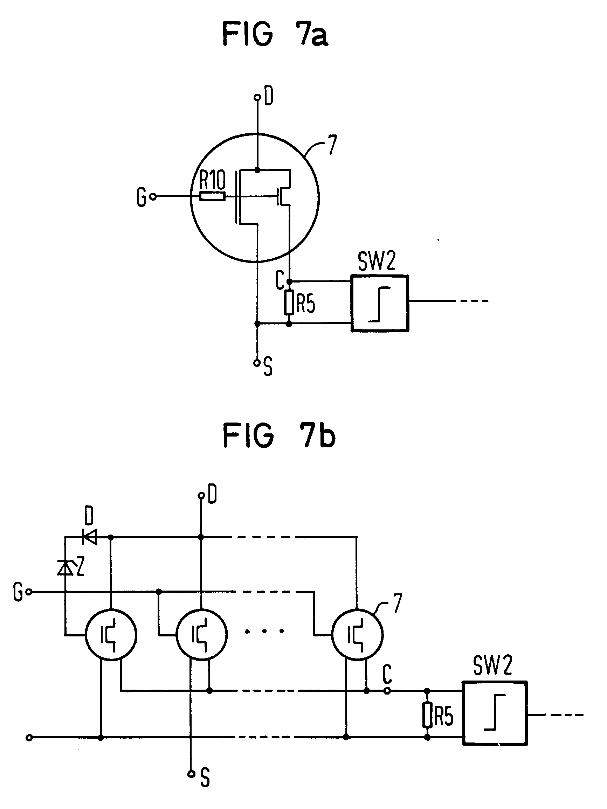

In den FIG 7a und 7b sind Beispiele für Leistungsschaltstufen dargestellt. FIG 7a zeigt einen Leistungs-MOS-FET mit vier Anschlüssen, nämlich dem Gateanschluß G mit in Reihe geschalteten Entkopplungswiderstand R10, dem Drainanschluß D, dem Sourceanschluß S und einem integrierten Stromsensorausgang C. Dieser integrierte Stromsensorausgang C ist zur Strommessung vorgesehen. Der an diesen integrierten Stromsensorausgang C fließende Strom ist direkt proportional zum Laststrom und bildet so eine sehr gute Möglichkeit den Laststrom zu messen. Ein Beispiel für eine solchen MOS-FET ist z.B. in EDN, July 10, 1986, S.56 beschrieben.

FIG 7b zeigt eine Leistungsschaltstufe, die mehrere parallel geschaltete wie in FIG 7a dargestellte Leistungs-MOS-FET zeigt. Dadurch besteht die Möglichkeit höhere Ströme zu schalten. Zur Unterdrückung von transienten Überspannungen ist eine Schwellwertgegenkopplung vorgesehen. Dazu ist an dem gemeinsamen Gateanschluß der Parallelschaltung die Anode einer Zenerdiode Z angeschlossen, deren Kathode mit der Anode einer Diode D verbunden ist. Die Kathode dieser Diode D ist mit dem gemeinsamen Drainanschluß verbunden.

Die zweite Ansteuereinheit 12 ist in der Weise an die Leistungsstufe 7 nach FIG 7a bzw. FIG 7b angeschlossen, daß der Gateanschluß G mit der Anschlußklemme 60 und der Sourceanschluß S mit der Anschlußklemme 61 verbunden ist. Zur Laststromüberwachung wird die an einem zwischen dem Stromsensorausgang C und Sourceanschluß S angeschlossenen Widerstand R5 abfallende Spannung abgegriffen und dem Schwellwertschalter SW 2 zugeführt, der beim Überschreiten eines entsprechenden Sollwertes eine logische "1" an seinem Ausgang erzeugt. Die Last wird dann in bekannter Weise mit dem Gateanschluß G und Drainanschluß der Leistungsschaltstufe 7 bzw. mit der Leistungsschaltstufe 7' verbunden.

Die Wirkungsweise der zweiten Ansteuereinheit 12 und die Ansteuerung der Halbbrücke nach FIG 3 wird im folgenden anhand von FIG 8 erläutert: Der Signalverlauf $u_2$ der Impulsketten wird auf zwei komplementär arbeitende sekundäre Ausgänge des Impulsübertragers 11' tranformiert. Der Impulsübertrager 11' weist also zwei sekundäre komplementär arbeitende Wicklungspaare auf, nämlich das Wicklungspaar $W_3$, $W_4$ und das Wicklungspaar $W_5$, $W_6$ (nicht gezeichnet). An das Wicklungspaar $W_3$, $W_4$ ist die zweite Ansteuereinheit 12 und an das Wicklungspaar $W_5$, $W_6$ die zweite Ansteuereinheit 12' geschaltet. Beide Ansteuereinheiten 12 und

12′ sind gleich aufgebaut. Die Spannung $u_5$ lieft zwischen den Anschlußklemmen 51 und 52 der zweiten Ansteuereinheit 12′ an, die Spannung $\overline{u}_5$ entsprechend zwischen deren Anschlußklemmen 53 und 52.

Dazu wird nach $u_1$ = "1" wegen der Laufzeitverzögerung im RS-Flip-Flop mit dem zweiten positiven Impuls von $u_4$, das ist die zwischen den Anschlußklemmen 51 und 52 anliegende Spannung, ein JK-Flip-Flop in der entsprechenden Ansteuereinheit 12 auf "1" gesetzt und die Leistungsschaltstufe 7 eingeschaltet. Zuvor wurde mit dem ersten negativen Impuls von $u_5$ der entsprechende Flip-Flop rückgesetzt und dadurch die Leistungsschaltstufe 7′ gesperrt. Die hierbei gegebene Einschaltverzögerung T1 stellt sicher, daß die Leistungsschaltstufen 7 und 7′ keineswegs gleichzeitig leiten.

Mit $u_1$ = "0" und mit dem ersten negativen Impuls von $u_4$ wird die Leistungsschaltstufe 7 gesperrt und nach der Verzögerung von T1 wird mit dem zweiten positiven Impuls von $u_5$ die Leistungsschaltstufe 7′ eingeschaltet.

FIG 8 zeigt das in der zweiten Ansteuereinheit 12 regenerierte Blocksignal $u_7$ zur Ansteuerung der Leistungsschaltstufe 7 und das in der zweiten Ansteuereinheit 12′ entsprechend regenerierte Blocksignal $u_8$.

Ein gleichzeitiges Sperren beider Leistungsschaltstufen 7 und 7′ wird dadurch herbeigeführt, daß die Pulsfolge mit der Periode T primärseitig durch "Impulssperre" unterdrückt wird, wobei das Setzen der sekundärseitigen SpeicherFlip-Flop in den zweiten Ansteuereinheiten 12 und 12′ unterbleibt und die Rücksetzvorgänge unbeeinträchtigt bleiben. Bei Anbieten eines alternierenden Steuersignals $u_1$ und des Impulssperresignals werden also die Leistungsschaltstufen 7 und 7′ gesperrt.

Ein Störzustand, wie Überstrom und/oder Übertemperatur undoder Überspannung wird durch Setzen der monostabilen Kippstufe MO3, welche den Schalter übergeordnet sperrt, beantwortet. Gleichzeitig wird dadurch eine Last R6 eingeschaltet, welche auf der Primärseite einen erhöhten Speisestrom nach sich zieht, was detektiert und gemeldet wird. So wird z.B. mittels eines sourceseitigen Stromfühlers, Überstrom erkannt und die monostabile Kippstufe MO3 gesetzt, die über das Gatter G7 die Schaltstufe sperrt. Die Stromprüfung wird jeweils dann vorgenommen, wenn der Q-Ausgang des JK-Flip-Flops logisch "1" ist und zwar nach einer Verzögerung von T3. Auf diese Weise wird verhindert, daß gegebenenfalls überhöhte Ströme bei der Kommutierung als Störung interpretiert werden. Ein Setzen dieser monostabilen Kippstufe wird auch durch die temperaturempfindliche Anordnung TA veranlaßt. Die monostabile Kippstufe MO3 schaltet im weiteren eine zusätzlich Belastung R6 für UB1 ein, was auf der Primärseite des Impulsübertragers 11′ erkannt wird. Die Spannung UB1 wird mittels dem Schwellwertschalter SW1 überwacht. Ist sie zu niedrig, wird über das Gatter G7 das JK-Flip-Flop zurückgesetzt.

**Patentansprüche**

1. Schaltungsanordnung eines sich selbst schützenden Leistungsschalters mit Anschlußklemmen für Steuersignale, Versorgungsspannung, Statussignal und Last, und mit einer Ansteuer- und Überwachungseinrichtung (6) für mindestens eine Leistungsschaltstufe (7), die mindestens eine erste Ansteuereinheit (10) und eine zweite Ansteuereinheit (12) enthält, zwischen die ein Impulsübertrager (11) geschaltet ist, mit in der zweiten Ansteuereinheit (12) vorgesehenen, an die Sekundärwicklung des Impulsübertragers (11) angeschlossenen Mitteln, die die Leistungsschaltstufe abhängig von den Steuersignalen ein- und ausschalten und die die Leistungsschaltstufe bei Überlast sperren und über einen steuerbaren Schalter eine Last an die Sekundärwicklung schalten, mit Mitteln in der ersten Ansteuereinheit (10), die das Einschalten der Last als Überlast bewerten, **dadurch gekennzeichnet,** daß die erste Ansteuereinheit (10) die Steuersignale in Impulsketten umwandelt, daß die zweite Ansteuereinheit (12) die Impulsketten zu Steuersignalen regeneriert, daß die Mittel in der zweiten Ansteuereinheit einen von den regenerierten Steuersignalen angesteuerten Treiber (TE6) zum Schalten der Leistungschaltstufen (7) enthalten, daß der Schalter (TR3) ausschließlich die Last schaltet, daß der Treiber bei Überlast gesperrt wird und daß der Schalter bei Überlast vom regenerierten Steuersignal leitend gesteuert wird.

2. Schaltungsanordnung nach Anspruch 1, **dadurch gekennzeichnet,** daß die Mittel in der zweiten Ansteuereinheit (12) die Leistungsschaltstufe (7) übergeordnet sperren.

3. Schaltungsanordnung nach Anspruch 1 oder 2, **dadurch gekennzeichnet,** daß die Leistungsschaltstufe Transistoren mit Feldeffekt-Steuereingängen enthält.

4. Schaltungsanordnung nach einem der Ansprüche 1 bis 3, **dadurch gekennzeichnet,** daß in der zweiten Ansteuereinheit (12) eine Gleichrichteranordnung angeordnet ist, die aus den durch den Impulsübertrager (11) entsprechend transformierten Impulsketten die Versorgungsspannung für die zweite Ansteuereinheit (12) liefert.

5. Schaltungsanordnung nach einem der Ansprüche 1 bis 4,
**dadurch gekennzeichnet,** daß die Impulsketten einen Startimpuls mit nachfolgender verzögerter Pulsfolge aufweisen, und daß der erste Pulsfolgenimpuls der ersten Impulskette den Beginn des Blocksignals für die Steuerung der Leistungsschaltstufe (7) definiert, und daß der Startimpuls der zweiten Impulskette das Ende dieses Blocksignals definiert.

6. Schaltungsanordnung nach einem der Ansprüche 1 bis 5,
**dadurch gekennzeichnet,** daß der Impulsübertrager (11') zwei komplementär arbeitende sekundäre Wicklungspaare ($W_3$, $W_4$,; $W_5$, $W_6$) aufweist, und daß an das zweite sekundäre Wicklungspaar ($W_5$, $W_6$) eine weitere zweite Ansteuereinheit (12') mit einer Leistungsschaltstufe (7') geschaltet ist, und daß die Leistungsschaltstufen (7, 7') als Halbbrücke miteinander verbunden sind.

7. Schaltungsanordnung nach Anspruch 1,
**dadurch gekennzeichnet,** daß die Mittel in der zweiten Ansteuerstufe (12) eine temperaturempfindliche Anordnung (TA) enthalten, die bei Überschreiten einer vorgegebenen Temperatur der Leistungsschaltstufe den Schalter (TR3) leitend steuert und den Treiber (TE6) sperrt.

**Claims**

1. Circuit arrangement of a self-protecting power circuit breaker having connecting terminals for control signals, supply voltage, status signal and load, and having a drive and monitoring device (6) for at least one power switching stage (7) which contains at least a first drive unit (10) and a second drive unit (12), between which there is connected a pulse transmitter (11), having means provided in the second drive unit (12) and connected to the secondary winding of the pulse transmitter (11) which switch the power switching stage on and off as a function of the control signals and which block the power switching stage in the event of an overload and, via a controllable switch, switch a load to the secondary winding, having means in the first drive unit (10) which assess the switching on of the load as an overload, characterised in that the first drive unit (10) converts the control signals into pulse chains, in that the second drive unit (12) regenerates the pulse chains into control signals, in that the means in the second drive unit contain a driver (TE6), driven by the regenerated control signals, for switching the power switching stages (7), in that the switch (TR3) exclusively switches the load, in that the driver is blocked in the event of overload and in that the switch is controlled by the regenerated control signal in a conducting manner in the event of overload.

2. Circuit arrangement according to Claim 1, characterised in that the means in the second drive unit (12) block the power switching stage (7) in a higher-level manner.

3. Circuit arrangement according to Claim 1 or 2, characterised in that the power switching stage contains transistors having field-effect control inputs.

4. Circuit arrangement according to one of Claims 1 to 3, characterised in that, in the second drive unit (12), there is arranged a rectifier arrangement which supplies the supply voltage for the second drive unit (12) from the pulse chains which have been suitably transformed by the pulse transmitter (11).

5. Circuit arrangement according to one of Claims 1 to 4, characterised in that the pulse chains have a start pulse with a subsequent, delayed pulse sequence, and in that the first pulse sequence pulse of the first pulse chain defines the start of the block signal for controlling the power switching stage (7), and in that the start pulse of the second pulse chain defines the end of this block signal.

6. Circuit arrangement according to one of Claims 1 to 5, characterised in that the pulse transmitter (11') has two pairs of secondary windings ($W_3$, $w_4$; $w_5$, $W_6$), operating in a complementary manner, and in that a further, second drive unit (12'), having a power switching stage (7'), is connected to the second pair of secondary windings ($W_5$, $W_6$), and in that the power switching stages (7, 7') are connected to one another as a half bridge.

7. Circuit arrangement according to Claim 1, characterised in that the means in the second drive stage (12) contain a temperature-sensitive arrangement (TA), which controls the switch (TR3) in a conducting manner, in the event of a predetermined temperature of the power switching stage being exceeded, and blocks the driver (TE6).

**Revendications**

1. Montage d'un interrupteur de puissance réalisant une protection automatique, comportant des bornes de raccordement pour des signaux de commande, une tension d'alimentation, un signal d'état et une charge, et comportant un dispositif de commande et de contrôle (6) pour au moins un étage d'interruption de puissance (7), qui comporte au moins une première unité de commande (10) et une seconde unité de commande (12), entre lesquelles est branché un transformateur d'impulsions (11), et comportant des moyens, qui sont prévus dans la seconde unité de commande (12), sont raccordés à l'enroulement secondaire du transformateur d'impulsions (11) et branchent et débranchent l'étage d'interruption de puissance en fonction des signaux de commande, bloquent l'étage d'interruption de puissance dans le cas d'une surcharge et raccordent une charge à l'enroulement secondaire par l'intermédiaire d'un interrupteur commandable, et comportant des moyens situés dans la première unité de commande (10) et qui évaluent le branchement de la charge en tant que surcharge, caractérisé par le fait que la première unité de commande (10) convertit les signaux de commande en des suites d'impulsions, que la seconde unité de commande (12) régénère les suites d'impulsions en forme de signaux de commande, que les moyens situés dans une unité de commande contiennent un étage d'attaque (TE6) commandé par les signaux de commande régénérés et servant à raccorder les étages d'interruption de puissance (7), que l'interrupteur (TR3) raccorde exclusivement la charge, que dans le cas d'une surcharge, l'étage d'attaque et bloqué et que dans le cas d'une surcharge, l'interrupteur est placé à l'état conducteur par le signal de commande régénéré.

2. Montage suivant la revendication 1, caractérisé par le fait que les moyens situés dans la seconde unité de commande (12) bloquent, selon une commande prioritaire, l'étage d'interruption de puissance (7).

3. Montage suivant la revendication 1 ou 2, caractérisé par le fait que l'étage d'interruption de puissance comporte des transistors possédant des entrées de commande à effet de champ.

4. Montage suivant l'une des revendications 1 à 3, caractérisé par le fait que dans la seconde unité de commande (12) est prévu un dispositif redresseur, qui fournit, à partir des suites d'impulsions transformées de façon correspondante par le transformateur d'impulsions (11), la tension d'alimentation pour la seconde unité de commande (12).

5. Montage suivant l'une des revendications 1 à 4, caractérisé par le fait que les suites d'impulsions possèdent une impulsion de démarrage suivie par une suite d'impulsions retardée, et que la première impulsion de la première suite d'impulsions définit le début du signal de blocage pour la commande de l'étage d'interruption de puissance (7), et que l'impulsion de démarrage de la seconde suite d'impulsions définit la fin de ce signal de blocage.

6. Montage suivant l'une des revendications 1 à 5, caractérisé par le fait que le transformateur d'impulsions (11') possède deux couples d'enroulements secondaires ($W_3,W_4;W_1,W_6$), qui opèrent de façon complémentaire, et qu'au second couple d'enroulements secondaires ($W_5,W_6$) est raccordée une autre seconde unité de commande (12') comportant un étage d'interruption de puissance (7'), et que les étages d'interruption de puissance (7,7') sont raccordés entre eux sous la forme d'un demi-pont.

7. Montage suivant la revendication 1, caractérisé par le fait que les moyens situés dans le second étage de commande (12) contiennent un dispositif (TA) sensible à la température, qui, dans le cas du dépassement d'une température prédéterminée de l'étage d'interruption de puissance, place l'interrupteur (TR3) à l'état conducteur et bloque l'étage d'attaque (TE6).

# FIG 1

# FIG 2

# FIG 3

# FIG 5

# FIG 4

EP 0 268 930 B1

FIG 6

## FIG 7a

## FIG 7b

# FIG 8